# EUROPEAN PATENT APPLICATION

(11) **EP 0 895 326 A1**
(43) Date of publication of application: **03.02.1999**
(21) Application number: 98114009.8
(22) Date of filing: 27.07.1998
(51) Int. Cl.: H01S 3/25

(54) **Semiconductor optical amplifier**

(30) Priority: 28.07.1997 JP 201830/97
(71) Applicant: NEC CORPORATION, Tokyo (JP)
(72) Inventor: Kitamura, Shotaro, c/o NEC Corporation, Tokyo (JP)
(74) Representative: Glawe, Delfs, Moll & Partner

(57) **Abstract**

Reflectivity at a facet of a slanted facet SOA is reduced to the extent that gain ripple can be suffciently restricted even for the SOA gain as high as 30dB. The slanted facet SOA comprises an optical waveguide type active layer 12 and portions of the optical waveguide in the vicinity of facets 14 thereof being cut away to provide window regions 15, a thickness or width of at least a portion of the optical waveguide being reduced gradually to provide a tapered waveguide 16 such that radiation angle of an output light has Full Width at Half Maximum of 15 degree or less and a normal line of the facet 14 making an angle of 6 degree or more with respect to a longitudinal direction of the optical waveguide. When length of the window region 15 is in a range from 50µm to 80µm, the normal line of the facet 14 makes an angle of 5 degree or more with respect to the longitudinal direction of the optical waveguide.

## Description

### BACKGROUND OF THE INVENTION

### Field of the Invention

The present invention relates to a structure of a semiconductor optical amplifier which is used in an optical communication technology and has an optical signal amplifying function or an optical signal extinguishing function.

### Description of the Related Art

A semiconductor optical amplifier (referred to as "SOA", hereinafter) has an optical waveguide as an optical amplifying medium and is adapted to amplify an optical signal directly without using the opto-electric conversion. The structure of SOA is basically the same as that of a semiconductor laser, except that light reflection at facets of the SOA is restricted by using anti-reflection coatings in order to prevent an optical resonator structure from being formed. Therefore, laser oscillation of the SOA itself is restricted even when carrier is injected thereinto and an amplified output signal light is obtained by stimulated emission due to an input signal light. If the light reflectivity at the facet of the SOA is not restricted sufficiently, wavelength dependent gain vibration (ripple), that is, small variation of gain due to variation of wavelength in the order of several Ångstrom, occurs. Therefore, the reflectivity of light at the facet of the SOA as low as 0.1% or less is usually required. In order to achieve such low reflectivity of light at the SOA facet, a structure of the SOA with which a reflected light at the facet is not coupled back to an optical waveguide is employed to effectively lower the reflectivity at the facet.

An optical waveguide structure in which, in order to lower the reflectivity of light at facets of an SOA, window regions are provided in the vicinity of the facets of the SOA by breaking off opposite end portions of the waveguide has been proposed in Article 1.

Article 1: I. Cha et al, "1.5µm BAND TRAVELLING-WAVE SEMICONDUCTOR OPTICAL AMPLIFIERS WITH WINDOW FACET STRUCTURE", Electronics Letters, Vol. 25, No. 18, pp. 1241 to 1242 (August 31, 1989).

An angled facet structure in which a stripe direction of an optical waveguide is slanted from normal lines of facets of an SOA has been proposed in Article 2.

Article 2: C.E. Zah et al, "FABRICATION AND PERFORMANCE OF 1.5µm GaInAsP TRAVELLING-WAVE LASER AMPLIFIERS WITH ANGLED FACETS", Electronics Letters, Vol. 23, No. 19, pp. 990 to 991 (September 10, 1987).

Further, there are many reports of SOA recently in which both the window region structure and the angled facet structure are combined and the following Articles are examples thereof.

Article 3: W. Hunziker et al, "Self-aligned Tilted Amplifier Array Packaging using Si V-groove Flip-Chip Technique for Gate Array Applications", Optical Amplifiers and Their Applications '94, Post-deadline Papers, pp. PD4-2 to PD4-4 (1994).

Article 4: L.F. Tiemeijer et al, "Progress in 1.3µm Polarization Insensitive Multiple Quantum Well Laser Amplifiers", Optical Amplifiers and Their Applications '94, Technical Digest, pp. 34/WD1-1 to 36/WD1-3 (1994).

Article 5: P. Doussiere et al, "1550 nm POLARIZATION INDEPENDENT DBR GAIN CLAMPED SOA WITH HIGH DYNAMIC INPUT POWER RANGE", 22nd European Conference on Optical Communication - ECOC '96, Oslo, Proceeding Vol. 3, WeD.2.4, pp. 169 to 172.

Article 6: S. Chelles et al, "POLARIZATION INSENSITIVE WAVELENGTH CONVERSION BY CROSS GAIN MODULATION IN A STRAINED MQW OPTICAL AMPLIFIER", 22nd European Conference on Optical Communication - ECOC '96, Oslo, Proceeding Vol. 4, ThB.2.5, pp. 53 to 56.

Article 3 discloses that a fiber-to-fiber gain in the order of about 10dB is obtained by directly coupling an angle polished single mode fiber (SMF) to an SOA optically. Articles 4, 5 and 6 disclose SOA modules which are optically coupled to lensed SMF's. According to these reports, a fiber-to-fiber gain of 20dB or larger is realized. Further, in Articles 4, 5 and 6, regardless of SOA gain as large as about 30dB, the gain ripple is restricted to 1dB or less by the restriction of the reflectivity obtained by the tilted facet structure and the window regions.

There is a recent tendency of simple SOA module in which an SOA and a single mode fiber (referred to as "SMF", hereinafter) are optically connected directly without using any lens system. For example, an SOA module has been studied in which, in order to facilitate an optical coupling of an SOA with an SMF, the SOA is provided with a spot size enlarging structure in which thickness or width of an optical waveguide is tapered to narrow radiation angle of an output light. With such spot size enlarging structure, the effect of reduction of reflectivity due to employment of both the window regions and the tilted facet structure becomes substantial although the effect of reduction of reflectivity by only the window region is degraded. Therefore, it is indispensable in the spot size enlarger to employ, in addition to the formation of the window region, the tilted facet structure. However, in the tilted facet structure, there is a problem that an error in an end-to-end distance between an SOA and an SMF in coupling them causes an optical axis of the SOA module to be moved, resulting in large optical coupling loss.

### SUMMARY OF THE INVENTION

An object of the present invention is to provide a semiconductor optical amplifier including an optical waveguide having facets a tilting angle of which is set such that gain ripple is sufficiently restricted even at gain as high as about 30dB, an increase of optical coupling loss is minimized and the reflectivity of facets thereof is reduced sufficiently.

In order to achieve the above object, a semiconductor optical amplifier according to an aspect of the present invention comprises an optical waveguide type active layer and window regions provided by making the optical waveguide discontinuous in the vicinity of facets of the semiconductor optical amplifier, wherein a thickness or width of at least a portion of the optical waveguide is gradually changed by tapering the portion such that a radiation angle of an output light has Full Width at Half Maximum (FWHM) of 15 degree or less and a normal line of the facet makes an angle of 6 degree or more with respect to a longitudinal direction of the optical waveguide.

According to another aspect of the present invention, a semiconductor optical amplifier comprises an optical waveguide type active layer and window regions provided by making the optical waveguide discontinuous in the vicinity of facets of the semiconductor optical amplifier, wherein a thickness or width of at least a portion of the optical waveguide is gradually changed by tapering the portion such that a radiation angle of an output light has FWHM of 15 degree or less and a length of the window region is not less than 50µm and not more than 80µm and a normal line of the facet makes an angle of 5 degree or more with respect to a longitudinal direction of the optical waveguide.

### BRIEF DESCRIPTION OF THE DRAWINGS

This above-mentioned and other objects, features and advantages of the present invention will become more apparent by reference to the following detailed description of the invention taken in conjunction with the accompanying drawings. in which:
Fig. 1a is a plan view of a semiconductor optical amplifier according to the present invention;
Fig. 1b is a cross section taken along a line a-a' in Fig. 1a;
Fig. 2 is a graph showing a relation between light radiation angle in Full Width at Half Maximum and optical coupling loss;
Fig. 3 is a graph showing a relation between tilt angle of a slanted facet structure and reflectivity at the facet;
Fig. 4 illustrates an optical axis difference between SOA and SMF;
Fig. 5 is a graph showing a relation between tilt angle of a slanted facet structure and optical coupling loss;
Fig. 6 is a graph showing a relation between length of a window region and reflectivity at a facet of SOA; and
Fig. 7 is a graph showing a relation between length of a window region and optical coupling loss.

### DETAILED DESCRIPTION OF THE PREFERRED EMBODIMENTS

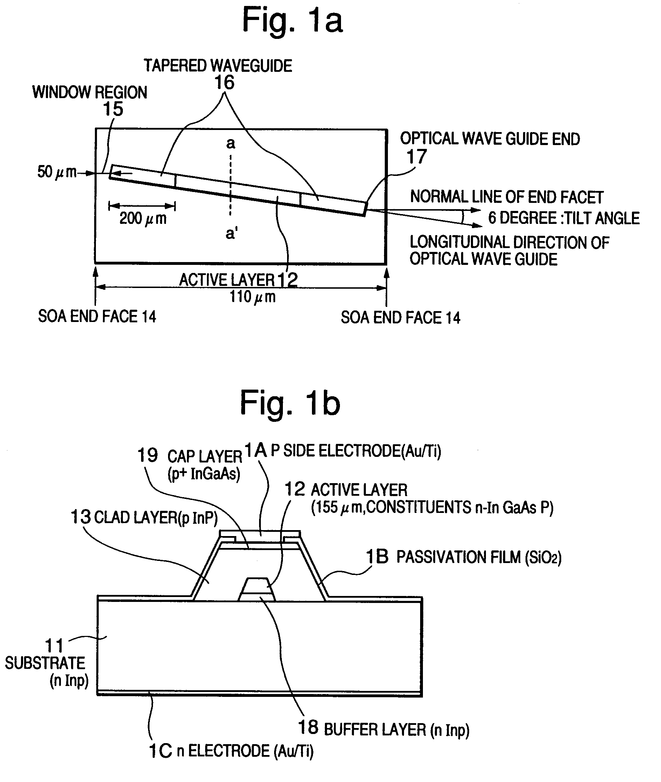

Figs. 1a and 1b show an embodiment of a semiconductor optical amplifier (SOA) of the present invention.

In this embodiment of the present invention, in order to obtain an acceptable optical coupling between the SOA and a single mode fiber (SMF), a tapered waveguide 16 having a thickness or width which is gradually reduced toward opposite ends thereof, that is, having a light spot size enlarging structure, is provided in the SOA to narrow a radiation angle of an output light. The tapered waveguide 16 will be described in detail.

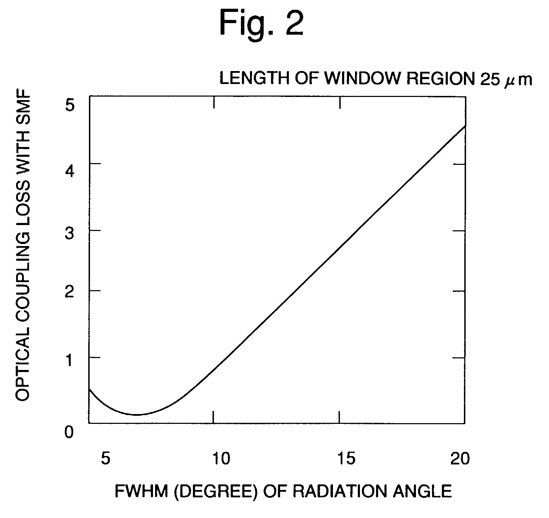

In order to determine a configuration of the tapered waveguide, a relation between optical coupling loss (estimated value) with respect to an SMF and radiation angle was obtained by using a usual SOA having identical vertical and horizontal light spot diameters and window regions each 25µm long. A result is shown in Fig. 2. Incidentally, calculation of the estimated value was performed by approximating light field distribution to Gaussian distribution. From Fig. 2, it is clear that, in order to make the optical coupling loss with respect to the SMF 3dB which is usually required value or less, the radiation angle must be FWHM of 15 degree or smaller.

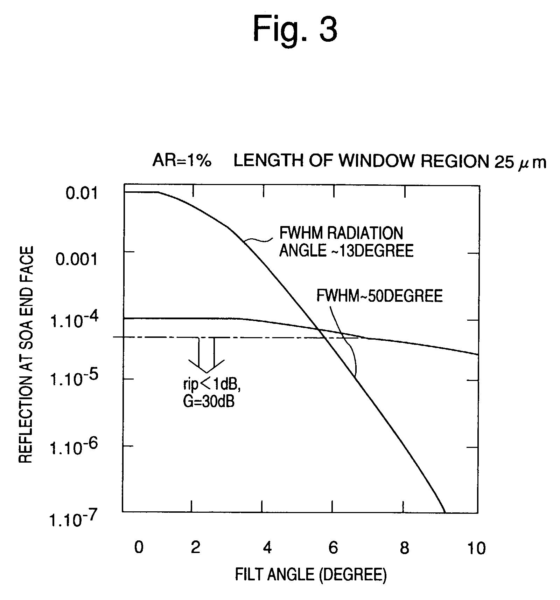

In a case where the radiation angle is narrowed by forming the tapered waveguide 16, however, it is necessary in order to lower reflectivity at facets of the SOA to employ a slanted facet structure. In order to determine the tilt angle of the facet, a relation between tilt angle of the facet and reflectivity of the facet was obtained. A result is shown in Fig. 3. In this case, the radiation angle was FWHM of 13 degree or less and the window region was 25µm long, which satisfy the above conditions, and reflectivity of anti-reflection (referred to as "AR", hereinafter) film was 1%. Fig. 3 also shows a relation between tilt angle of a facet and reflectivity of facet in a case where the radiation angle is FWHM of 50 degree or less, as a comparative example. From this result, it is clear that, with the small radiation angle (FWHM of 13 degree or less), although there is substantially no effect of reduction of reflectivity due to the window region in the vicinity of the tilt angle of 0 degree, reflectivity is rapidly lowered when the tilt angle is increased. Although the SOA gain of about 30dB is obtained, it is necessary in order to make gain ripple 1dB or less that reflectivity must be 5×10⁻⁵. Therefore, it is clear from Fig. 3 that the tilt angle must be 6 degree or more.

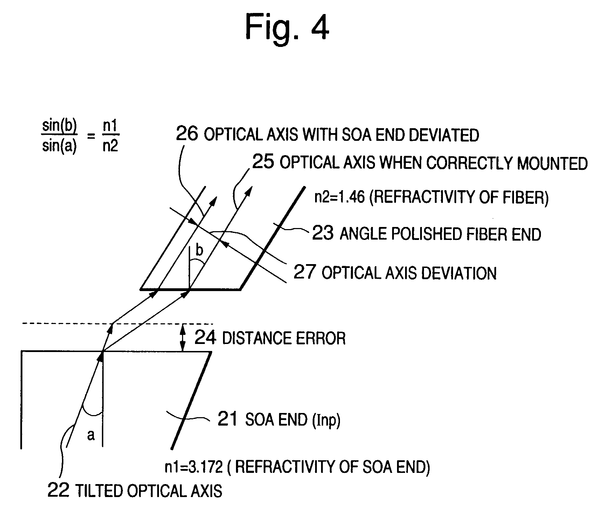

On the other hand, taking an increase of optical coupling loss due to mounting error into consideration, the tilt angle should be as small as possible. In the slanted facet structure, an end portion 23 of an angle polished fiber and an end portion 21 of the SOA are arranged according to Snell's law as shown in Fig. 4. In this case, however, when a distance between the end portion 21 of the SOA and the end portion 23 of the angle polished fiber in a mounted state is deviated from a design value, an optical axis deviation occurs. That is, when there is a distance error 24 between the SOA and the SMF, the optical axis 22 of the end portion 21 of the SOA is connected to not an optical axis 25 of the SMF in a designed place but to a deviated optical axis 26, resulting in the optical axis deviation 27. Therefore, the fabrication accuracy of the length of the semiconductor optical amplifier, etc., may influence the optical coupling loss.

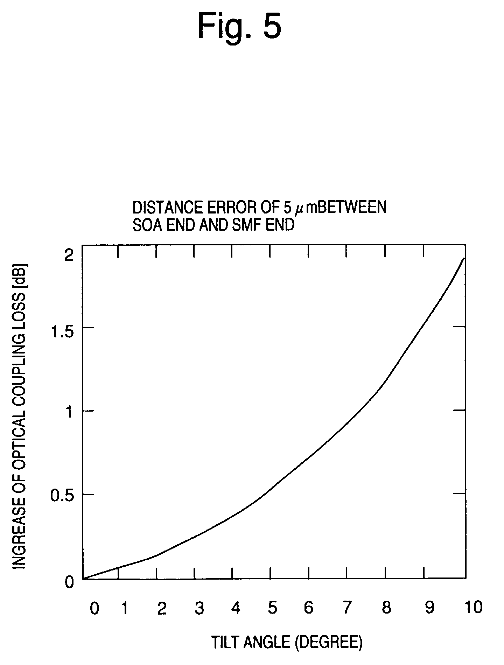

Fig. 5 is a graph showing a relation between increase of optical coupling loss (estimated value) due to optical axis deviation and tilt angle when the distance error of 5µm occurs in a case where the SOA having radiation angle of 13 degree is used and a design value of the distance between the SOA end portion and the SMF end portion is 10µm. Incidentally, the distance error of 5µm is a practical value which may be obtained in view of the currently available fabrication technology. As will be clear from Fig. 5, it is preferable in order to restrict the increase of optical coupling loss to make the tilt angle as small as possible and, concurrently, to reduce reflectivity. In order to realize this, it is enough to make the window region longer.

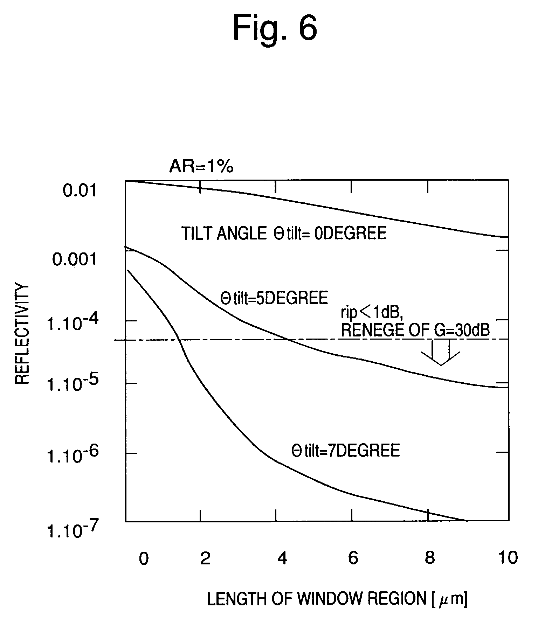

Fig. 6 shows a relation between length of window region and reflectivity in cases where the tilt angle of the facet is 0 degree, 5 degree and 7 degree. These data were also calculated by using the Gaussian approximation. In a case where the length of window region is 50µm which is longer than 20 to 30µm disclosed in the Articles 1, 4 and 6, reflectivity is as small as 5×10⁻⁵ even with tilt angle of 5 degree as shown in Fig. 6 and it is possible to make gain ripple as small as 1dB or less for SOA gain of 30dB. If tilt angle is further increased, gain ripple can be further reduced.

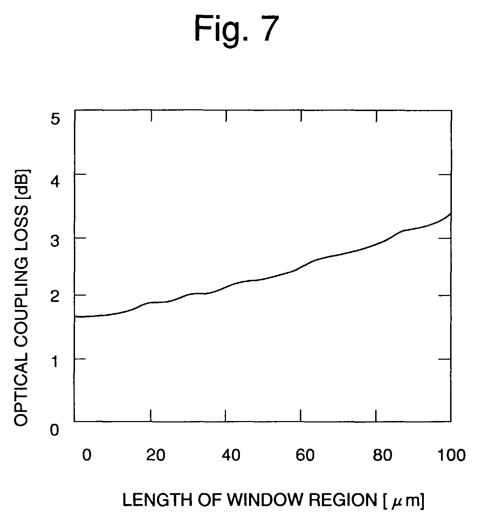

Incidentally, the increase of optical coupling loss due to increase of the length of window region from 20µm to 50µm is as small as 0.5dB as shown in Fig. 7. Even when the length of the window region is made longer up to 80µm, increase of optical coupling loss is 1dB or less.

As mentioned above, in order to obtain the SOA gain as high as 30dB or more while sufficiently restricting gain ripple in the SOA having light spot size enlarging structure including window regions of usual length, it is enough to set the tilt angle to 6 degree or more.

Further, in order to further reduce the reflectivity, it is enough to set the length of the window region to 50 ∼ 80µm. Since, when the window region is 50 ∼ 80µm long, the tilt angle can be restricted to 5 degree while sufficiently reducing the reflectivity, substantial optical axis deviation can be avoided.

The Articles 3, 4, 5 and 6 disclose SOA's having window regions and tilt facet structures which are similar to the present invention. Now, differences of the SOA's disclosed in these Articles from the SOA of the present invention will be described.

The constriction of the SOA disclosed in the Article 4 or 6 optically couples the SOA with the SMF by using the lens. Therefore, there is no need of particularly narrowing the radiation angle of the output light unlike the present SOA, so that there is no description about the radiation angle in these Articles.

The window region of the SOA disclosed in the Article 5 is much longer than that of the present SOA. However, since, in the Article 5, the SOA is optically coupled with the SMF by using the lens, the increase of optical coupling loss is restricted. Further, due to the use of the lens, there is no need of particularly narrowing the radiation angle of the output light unlike the present SOA.

In the Article 3, the SOA is directly coupled with the SMF as in the present invention. However, there is no description of the radiation angle in the Article 3. Further, since the gain of the SOA is in the order of 20dB, there is no need of optimizing the length of the window region, so that there is no description of the window region in the Article 3.

Now, preferred embodiments of the present invention will be described in detail with reference to the drawings.

### 〈Embodiment 1〉

Fig. 1(a) is a plan view showing a configuration of an optical waveguide of the semiconductor optical amplifier (SOA) according to a first embodiment of the present invention and Fig. 1(b) is a cross section taken along a line a-a' in Fig. 1(a), as mentioned previously. The SOA according this embodiment is formed on a substrate 11 by metal organic vapor phase epitaxy (MOVPE) and has a usual buried type (BH type) LD structure including a 1.55µm wavelength band active layer 12 buried in a clad layer 13. The active layer 12 is a bulk InGaAsP layer having a rectangular cross section 3000Å thick and 4500Å wide and provides polarization independent amplification gain. The clad layer 13 is of p type InP and the active layer 12 is buried therein to a depth of 5 µm. A cap layer 19 and a p side electrode 1A are formed on the clad layer 13 and a buffer layer 18 is formed below the active layer 12. An n side electrode 1C is formed on a whole lower surface of the SOA and a passivation film 1B is formed on a whole upper surface of the SOA.

As shown in Fig. 1(a), the optical waveguide has a tilt facet structure in which a longitudinal direction of the active layer 12 is tilted from a normal line of the facet by 6 degree. Portions of the active layer in the vicinity of the facets 14 are cut away to form window regions 15. Length of the SOA is 1100µm and both end portions of the active layer 12, each being 200µm long, are tapered such that thickness of each portion is gradually reduced toward an end thereof (from 3000Å to 800Å) to form the tapered waveguide 16 having a light spot size enlarging structure. With the tapered waveguide 16, the size of light spot is enlarged at an end 17 of the optical waveguide, facilitating a good optical coupling with the single mode fiber (SMF). Radiation angle of the output light is FWHM of 13 degree. Length of the window region 15 is 50µm. Anti-Reflection (AR) coatings of SiN film is formed on the respective facets of the SOA. The SOA according to this embodiment was fabricated by using the selective MOVPE technique disclosed in Article 7 below.

Article 7: T. Sasaki et al, "Optical Fiber Communication Conference '93 (OFC'93), Technical Digest ThK1", pp. 210 to 212 (1993).

An SOA module was fabricated by using a package in which SMF's each having an end polished with tilt angle of 13 degree are mounted on both ends of the SOA of this embodiment. The optical coupling between the SMF's and the SOA was acceptable and optical coupling loss was restricted to 3dB on each side. Evaluation of the gain characteristics of the SOA module shaw a module gain of 25dB at injection current of 150mA. Considering the optical coupling loss of 3dB on each side, the SOA gain is 30dB or more and there was substantially no gain ripple observed. That is, reflectivity at the facet of the SOA is restricted sufficiently.

### 〈Embodiment 2〉

An SOA having window region 70µm long and tilt angle of 5 degree was fabricated in the similar manner to that of Embodiment 1 and an SOA module was fabricated by using SMF's each having an end polished with tilt angle of 11 degree and mounted on both ends of the SOA. As in the case of Embodiment 1, the optical coupling between the SMF's and the SOA was acceptable and optical coupling loss was restricted to 3dB on each side. Evaluation of the gain characteristics of the SOA module shaw a module gain of 25dB at injection current of 150mA similarly to Embodiment 1. There was substantially no gain ripple observed. That is, reflectivity at the facet of the SOA is restricted sufficiently.

### 〈Embodiment 3〉

An SOA having window region 25µm long and tilt angle of 7 dgree was fabricated in the similar manner to that of Embodiment 1 and an SOA module was fabricated by using SMF's each having an end polished with tilt angle of 15.4 degree and mounted on both ends of the SOA. As in the case of Embodiment 1, the optical coupling between the SMF's and the SOA was acceptable and optical coupling loss was restricted to 4dB on each side. Evaluation of the gain characteristics of the SOA module shaw a module gain of 25dB at injection current of 200mA. There was substantially no gain ripple observed. That is, reflectivity at the facet of the SOA is restricted sufficiently.

As described hereinbefore, the semiconductor optical amplifier (SOA) of the present invention has the optical waveguide having tapered thickness or width, so that the spot size is enlarged to facilitate a direct optical coupling with single mode fibers (SMF's). Further, in the slanted facet SOA, it is possible to reduce reflectivity to the extent that gain ripple can be sufficiently restricted even for the SOA gain as high as 30dB.

## Claims

1. A semiconductor optical amplifier having an active layer in the form of an optical waveguide, portions of said optical waveguide in the vicinity of facets thereof being cut away to provide window regions, said semiconductor optical amplifier comprising:
said optical waveguide having at least a portion thereof, thickness of width of said portion being reduced gradually to provide a tapered structure such that radiation angle of an output light has Full Width at Half Maximum of 15 degree or less and a normal line of said facet makes an angle of 6 degree or more with respect to a longitudinal direction of said optical waveguide.

2. A semiconductor optical amplifier having an active layer in the form of an optical waveguide, portions of said optical waveguide in the vicinity of facets thereof being cut away to provide window regions, said semiconductor optical amplifier comprising:
said optical waveguide having at least a portion thereof, thickness or width of said portion being reduced gradually to provide a tapered structure such that radiation angle of an output light has Full Width at Half Maximum of 15 degree or less, length of said window region being in a range from 50µm to 80µm and a normal line of said facet makes an angle of 5 degree or more with respect to a longitudinal direction of said optical waveguide.
